# EUROPEAN PATENT SPECIFICATION

(11) **EP 0 419 136 B1**
(45) Date of publication and mention of the grant of the patent: **06.12.1995**
(21) Application number: 90310049.3
(22) Date of filing: 13.09.1990
(51) Int. Cl.: H01L 29/786

(54) **Electronic device with internal defect correction member**
Elektrische Halbleiteranordnung mit einem internen Fehlerkorrekturteil
Dispositif semi-conducteur comportant une partie interne pour corriger les défauts

(30) Priority: 13.09.1989 US 406946
(43) Date of publication of application: 27.03.1991
(73) Proprietor: XEROX CORPORATION, Rochester New York 14644 (US)
(72) Inventor: Jackson, Warren B., San Francisco, CA 94112 (US); Hack, Michael, Mountain View, CA 94040 (US)
(74) Representative: Reynolds, Julian David

(56) References cited:
- EP-A- 0 145 403
- EP-A- 0 166 261
- PATENT ABSTRACTS OF JAPAN, vol. 9, no. 204 (E-337)[1927], 21st August 1985 & JP-A-60 66 864
- APPLIED PHYSICS LETTERS, vol. 54, no. 7, 13th February 1989, pages 606-607, New York, US; T. MATSUMOTO et al.: "Threshold voltage shift of amorphous silicon thin-film transistors by step doping"
- PATENT ABSTRACTS OF JAPAN, vol. 10, no. 209 (E-421)[2265], 22nd July 1986 & JP-A-61 48 977
- APPLIED PHYSICS LETTERS, vol. 53, no. 26, 26th December 1988, pages 2617-2619, New York, US; Y.S. LEE et al.: "Thermally induced metastability in amorphous silicon thin-film transistors"

## Description

This invention relates to non-single crystal semiconductor devices.

Amorphous semiconductor materials, of which Si and Ge are the best known examples, are typically deposited by evaporation, sputtering, or plasma decomposition. The general view of such deposition processes is that the structure of the resulting material will be solely determined by the way in which the growing surface takes up the impinging atoms and forms a bonded network. It is also understood that the resulting material will be far from thermal equilibrium because the equilibrium state of any material is its crystalline form. Therefore, no amorphous or non-crystalline form is in complete equilibrium. For the sake of clarity, the following description will set forth primarily the amorphous silicon case, as exemplary. It should be borne in mind that the application of the present invention extends to other materials having similar equilibration mechanisms.

Samples of evaporated amorphous silicon deposited at low temperature (e.g. 100°C) have a high defect density, which may be substantially reduced by annealing to 250°C. Such a deposited amorphous silicon contains about 10¹⁹cm⁻³ dangling bond defects. It is well known that the defect density may be reduced by the addition of hydrogen, so that in the best hydrogenated glow discharge produced amorphous silicon the defect density may be about 10¹⁵cm⁻³. Annealing changes the structure in a way that approaches but does not reach the equilibrium state. If, instead, the deposited material is quenched at room temperature, it will freeze in a defect state comparable to an intermediate temperature, and self annealing will take place at room temperature over an extended period of time (on the order of a year or more).

However, the electronic properties of amorphous silicon are not only determined by the deposition process. Even after the material has been deposited and has achieved a metastable structure, its balance is disturbed, and new defects are generated, by the application of external perturbations or stresses, such as electrical bias during operation, thermal stressing and prolonged or intensive illumination. The defects which are created may be annealed away, with the equilibration time being inversely related to the annealing temperature. Equilibration is a term used to describe the spontaneous change in the density of gap states and, thereby, the electronic properties. The defects, or gap states, are dangling bonds whose density changes or is modified in response to the external stresses, because the material will modify itself in order to go to a more thermodynamically most stable state.

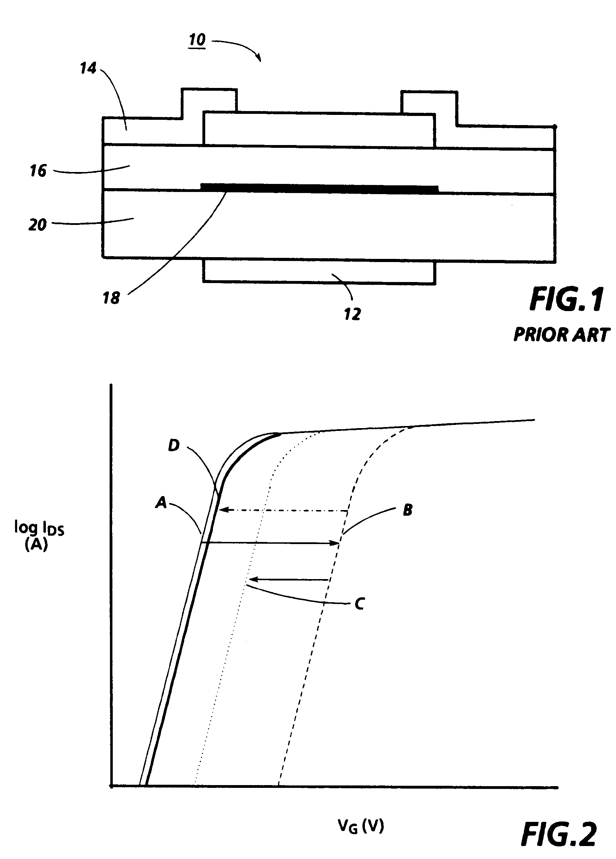

Whenever an electric bias is applied to such materials, they respond by generating defects to oppose the change which they undergo. For example, when a known n-channel, accumulation mode, low voltage, thin film transistor 10, as illustrated in Figure 1, is turned ON by applying a positive bias to the gate electrode 12, free electrons from the source electrode 14 enter the charge transport layer 16 to form an accumulation channel 18 at the interface with the gate dielectric 20. During accumulation the channel 18 is not in a stable state, since there are more free and trapped electrons therein. As it becomes more conductive its Fermi level rises to the conduction band. The amorphous semiconductor material always responds to the state of band bending by generating defects deep in the gap to oppose the change and to attempt to return the Fermi level to mid-gap by trapping free electrons in the extra defects. Then, upon removal of the gate bias, in the OFF condition of the transistor, the accumulation channel is extinguished and there will no longer be an excess of electrons, but the charge transport layer now has an excess of defects. Again the material will seek to equilibrate by removing the defects, but this will be an exceedingly slow process at room temperature.

The above described changes in response to the electrostatic stressing of the known low voltage amorphous silicon thin film transistor during its normal, intended use, may be seen in the shifting I_{DS} v. V_{G} curves illustrated in Figure 2. The transistor originally follows curve A. During its ON state, as defects are created to oppose accumulation, the curve may shift to B because free electrons, having fallen into the traps, no longer contribute to the current. More charge must be induced into the channel by a higher gate bias in order for the same current to flow. Then, when the device is returned to its OFF state, the charge transport layer again corrects itself by annealing away some of the defects and may return to the characteristics of curve C. This small threshold voltage (V_{T}) shift of the device will occur during each cycle. While the shift may not be large for any single ON-OFF cycle; over the lifetime of the device, there is a net drift which may cause the device to exhibit a threshold shift of several volts. To compensate for this shift in some applications, the gate can be overdriven by a margin of several volts.

Patent Abstracts of Japan, vol. 10, no. 209 (E-421)[2265], 22 July 1986 describes how the threshold voltage of a thin film transistor can be reduced by introducing donor and acceptor impurities in approximately equal quantities into a polycrystalline semiconductor film constituting the channel region.

In contrast, Matsumoto et al, "Threshold voltage shift of amorphous silicon thin-film transistors by step doping", pages 606 to 607, Appl. Phys. Lett. 54 (7), 13 February 1989 describes how the threshold voltage can be increased by using a step-doped structure comprising an undoped layer and a boron-doped layer, the undoped layer being located between the gate insulator and the doped layer. The doping ratio (gas phase ratio) for the doped layer is in the range 20 - 200 ppm.

Various other similar transistor structures are also known. For example, Patent Abstracts of Japan vol. 9, no. 204 (E-337)[1927], 21 August 1985 describes a structure similar to that described by Matsumoto et al (see above) in which the doped layer is an n-type amorphous silicon film and has a higher Fermi level than the undoped layer. EP-A-0 166 261 describes a field effect transisitor having a channel region formed of amorphous semiconductor material and, on one side or on both sides of the channel region, an field inducing layer which shifts the Fermi level of the channel region.

EP-A-0 145 403 describes various semiconductor devices, each of which includes a multiple layer semiconductor structure. By varying the composition of the layers, the characteristics of the multiple layer structure can be tailored to particular applications.

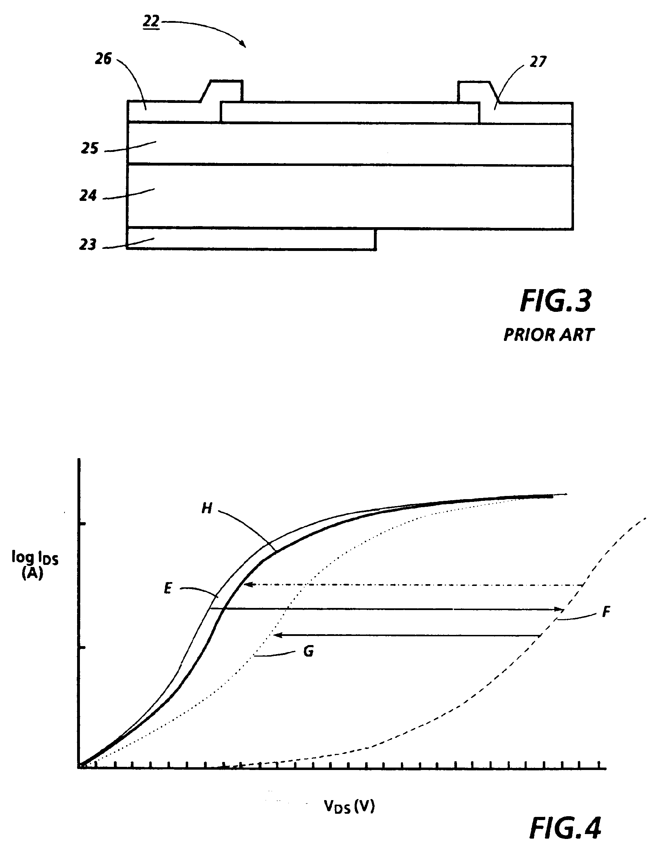

A known high voltage amorphous silicon thin film transistor 22 shown in Figure 3 comprises a gate electrode 23, a gate dielectric layer 24, a charge transport layer 25, a source electrode 26, and a drain electrode 27. The device will exhibit a threshold voltage shift, similar to that of the low voltage transistor of Figure 1, due to the effect of the bias applied to gate electrode 23. It will also exhibit a V_{X} shift due to the effect of the high drain potential on its "dead" (ungated) region during the OFF state of the device. The V_{X} shift is so called because it represents the difference between x-axis crossings of tangents to the inflection point of shifted I_{DS} vs. V_{DS} curves, illustrated in Figure 4. This phenomenon is fully described in European patent application No. 90 308 286.5 filed 27 July 1990. Briefly, in the OFF state of the device, electrons are swept out of the "dead" region, with the greatest depletion occurring in that portion of the dead region adjacent to the end of the gate. This depletion of electrons causes traps to be generated which, when charged, oppose the drain potential and requires a higher drain potential to be applied in order for the same amount of current to flow. Three curves are illustrated in Figure 4. These represent the original state of the device (curve E), the defect created V_{X} shifted state (curve F), and the self annealed, somewhat corrected state (curve G). Although it is often possible to work around these shifting characteristics without adverse effects, or corrective modifications may be made to the device structure, it would be desirable to prevent or eliminate them altogether.

For stability it is desired to maintain the gate control potential and the drain potential as low as possible. The present invention is concerned with providing an electronic device which will exhibit very small, if any, shifts in its characteristics in response to external perturbations. The invention is also concerned with accelerating the restoration of the active layer of an electronic device to its original state if changes occur therein in response to external perturbations.

The present invention provides a thin film transistor, including a gate electrode, a gate insulating layer, a charge transport layer and a correction layer formed in this sequence and adjacent each other, the charge transport layer comprising a non-single crystal, semiconductor layer (34) whose electronic structure changes in response to an external perturbation, the correcting layer comprising a semiconductor layer which contains substantially equal amounts of active n-type and p-type dopants, the correcting layer accelerating removal of said changes by providing carriers of the appropriate sign.

Preferably, the gate dielectric layer, located adjacent said correcting layer, is adapted to trap charges therein, and said correcting layer neutralizes said charges by providing said carriers of the appropriate sign when the number of active dopants is changed in said correcting layer.

By way of example only, embodiments of the invention will now be described with reference to the accompanying drawings, wherein:
Figure 1 (already referred to) illustrates a known low voltage thin film transistor,
Figure 2 (already referred to) illustrates output characteristic curves showing threshold voltage (V_{T}) shifting and recovery of the transistor of Figure 1.
Figures 3 (already referred to) illustrates a known high voltage thin film transistor,
Figure 4 (already referred to) illustrates output characteristic curves showing the V_{X} shifting and recovery of the transistor of Figure 3,
Figures 5 to 7 illustrate low voltage thin film transistors constructed in accordance with the present invention,
Figure 8 illustrates a high voltage thin film transistor constructed in accordance with the present invention,
Figure 9 illustrates a diode constructed in accordance with the present invention, and
Figure 10 illustrates a varactor constructed in accordance with the present invention.

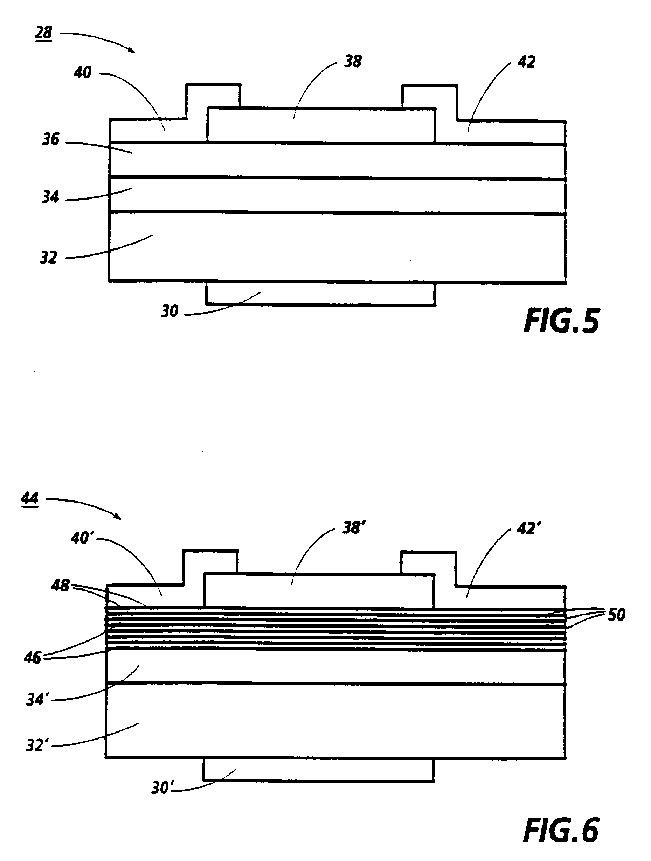

Turning now particularly to Figs. 5 to 10 of the drawings, there is illustrated in Figure 5 one form of a thin film transistor structure 28 constructed in accordance with the present invention. It comprises a substrate (not shown) which may be a sheet of glass or other material which is readily available in large area format, and is compatible with the device fabrication temperatures, on the order of 250°C, upon which is deposited a conductive gate electrode 30, which may be made of chromium. A silicon nitride gate dielectric layer 32 overlies the gate electrode, and a substantially intrinsic, or lightly doped, amorphous silicon charge transport layer 34 is deposited thereupon. A correcting layer 36, deposited adjacent to the charge transport layer comprises a compensated amorphous silicon material. As used herein, the term "adjacent" means close enough to allow for carrier interchange between the correcting member and the active charge transport layer and does not necessarily mean contact therebetween. If the charge transport layer has a thickness of about 30nm (300Å) of intrinsic amorphous semiconductor and the correcting layer has a thickness of about 30nm (300Å) of compensated material, the total thickness of these two layers will be about 60nm (600Å) (comparable to the thickness of the charge transport layer 16 in Figure 1) so that it still will be possible to self align source and drain electrodes through it, relative to the gate electrode. Furthermore, the standard fabrication process used to form the low voltage thin film transistor 10 is modified by simply depositing a lesser amount of intrinsic, or lightly doped, amorphous silicon material (layer 34), followed by the additional simultaneous introduction of a boron containing gas and a phosphorus containing gas. As in the Figure 1 device, a top nitride layer 38 is deposited over the correcting layer 36, and then it is patterned and etched to form vias for a deposited layer of phosphorus doped (n⁺) amorphous silicon which in turn is etched to form laterally spaced source electrode 40 and drain electrode 42. Chrome contacts overlying the n⁺ electrodes are not shown. The materials described above have been set forth only by way ofexample. We believe that the charge transport layer may also be made of GaAs and microcrystalline or polycrystalline forms of semiconductor materials.

The term compensated material is well understood to mean that the material is simultaneously doped with both n-type and p-type dopants, for example, phosphorus and boron, respectively. But whereas in single crystal silicon applications such a material includes equal amounts of n-type and p-type dopants, in amorphous silicon applications, wherein dopants are introduced in the gas phase, the amounts of active dopants in the deposited compensated material cannot be determined easily from the gas phase constituents alone. There is a tendency in amorphous silicon to self-compensation so that while the ratio of gas phase dopants may not be 1:1, the resultant amount of active dopants in the layer may be substantially equal. The spectrum of compensation in the correcting layer is broad and may be tailored to satisfy most requirements. It may range from perfect compensation, i.e. including substantially equal amounts of n-type and p-type dopants, to partial compensation, i.e. a ratio which may be as much as perhaps 1:10, or more.

An alternate configuration 44 of the low voltage thin film transistor is illustrated in Figure 6. The same elements are identified by the same numerals with a prime (′) attached. Transistor 44 differs from transistor 28, shown in Figure 5, in that the correcting member comprises a superlattice of sequentially deposited alternating n-type layers 46 and p-type layers 48 (npnp), which may or may not have intrinsic layers 50 sandwiched therebetween (nipi, as illustrated). Instead of being a mixture of dopants, as in the compensated layer, the dopants are spatially distinct. Each layer of such a superlattice may be about 1 to 5nm (10 to 50Å) thick. It is possible to tailor the superlattice structure to yield the desired characteristics by any of a number of ways. For example, the n or p layers may be deposited thicker than the other, more of one layer may be deposited than the other, or the dopant concentration of one set of the layers may be greater than the other. While it may be generally more desirable for there to be equal numbers of these layers of the same thickness and dopant concentration, so that the structure is electrically neutral, these suggested variations are possible and may benefit a particular application. In other words, control over the properties of the aggregate structure may easily be achieved by deposition control of the sequentially deposited layers. This degree of control is not achievable in a compensated layer because when the dopant containing gases are introduced simultaneously into the reaction chamber, the dopant atoms tend to pair up and it is very difficult to accurately control the numbers of free dopant atoms in the final layer. Another advantage of the nipi superlattice is the ability to use dopant materials which may tend to chemically react together, perhaps adversely. The superlattice allows the correcting member to have the desired properties while maintaining the dopant materials separate.

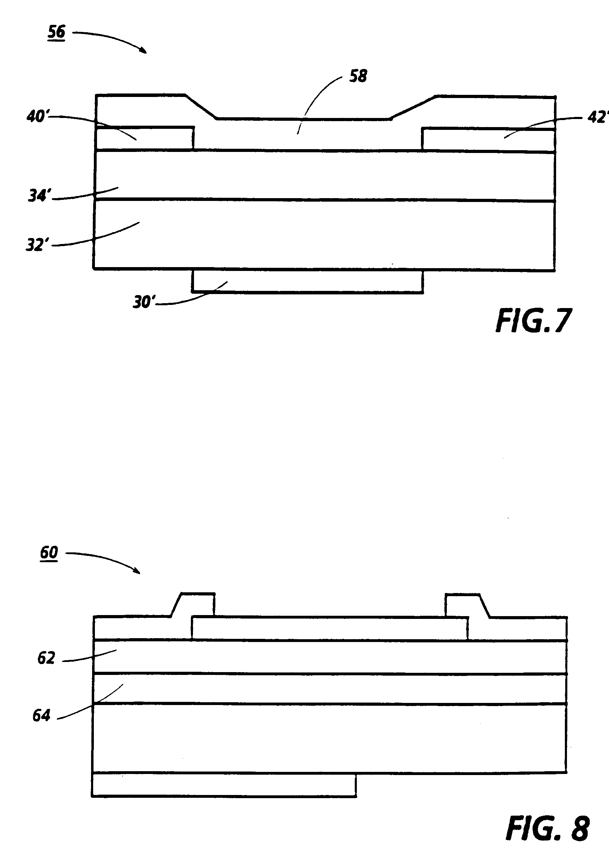

It is also possible to construct the low voltage thin film transistor 56 in the form shown in Figure 7. The deposition of the gate metal 30′, the gate dielectric 32′ and the charge transport layer 34′ follow the same process as in the fabrication of the devices of Figures 1, 5 and 6. Then an n⁺ semiconductor layer and a metal layer (not shown) are deposited, patterned and etched to form source and drain electrodes 40′ and 42′, with a channel region therebetween. Next, the correcting layer 58, such as a compensated layer, is deposited over the entire device and would be etched away in order to expose the source and drain contacts (not shown). The correcting member is adjacent to the charge transport layer in the stressed accumulation channel region, but is not interposed between the source and drain electrodes and the charge transport layer, as in the Figure 5 embodiment, where it may introduce a detrimental series resistance.

A high voltage thin film transistor 60, incorporating the present invention, is illustrated in Figure 8. It is comparable to transistor 22, shown in Figure 3 with the addition of a correcting layer 62 deposited adjacent to the substantially intrinsic, or lightly doped, charge transport layer 64. The various forms of the correcting member, illustrated and described relative to the low voltage thin film transistor, are equally applicable to the high voltage transistor.

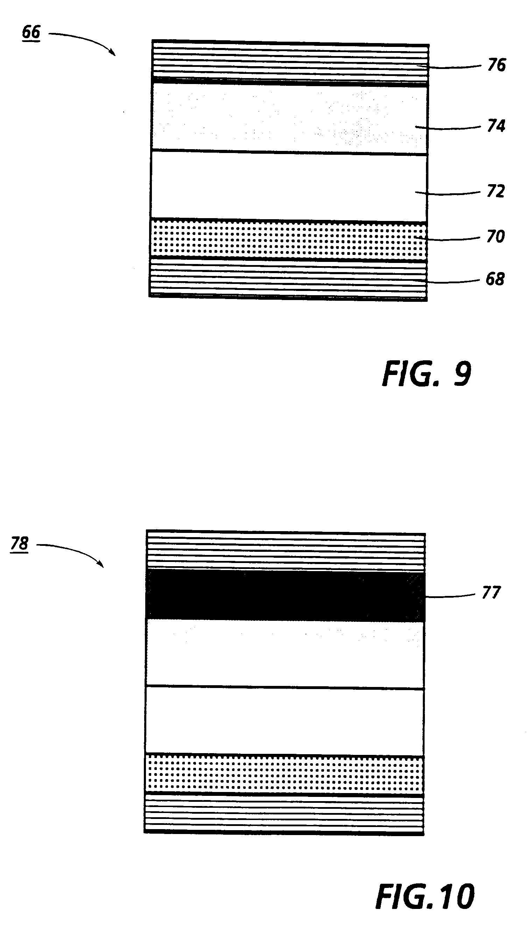

In fact, any amorphous semiconductor electronic device which equilibrates in response to external perturbations may be improved by the addition of a correcting member which supplies a source of appropriate charge. For example, the diode 66 of Figure 9 comprises an ohmic back contact including a metal electrode 68 and an n⁺ amorphous semiconductor layer 70, a correcting member 72, a substantially intrinsic amorphous semiconductor layer 74 and a collector electrode 76, which forms, together with the semiconductor layer 74, a Schottky barrier. With the addition of a dielectric layer 77 (as shown in Figure 10) which prevents the passage of current, a varactor 78 is formed. In each of these devices, the correcting layer 72 is a compensated layer for accelerating equilibration to the original device characteristics after electrostatic stressing.

In use in a thin film transistor, the defects formed in the amorphous semiconductor charge transport layer 34 (Figure 5), in response to the external perturbations, i. e. the positive gate potential, will be removed more rapidly when a supply of holes is made available nearby. The correcting layer, which may be in the form of the compensating layer 36, or a nipi or npnp superlattice will provide these necessary holes because the gate field, which induces electrons into the accumulation channel of the active layer, will also activate additional p-type dopants in these materials. In response to the gate field inducing electrons in the correcting layer and making it n-type, this member also equilibrates by the activation of more boron dopant atoms. Upon removal of the external stress, in the OFF state of the device, the correcting layer will have an excess of holes which act to speed up equilibration of the charge transport layer by depleting it of electrons. Curve D in Figure 2 represents the final state of the threshold voltage shift with the correcting member in place. It can be seen that we have been able to virtually eliminate the threshold voltage (V_{T}) shift.

In a similar manner, the correcting layer 62 (Figure 8) will accelerate equilibration of the "dead" (ungated) region of high voltage thin film transistor 48 when the device is at rest. In normal operation, in the OFF state of the device (V_{G} low, V_{DS} high), the dead region of the charge transport layer 64 will be depleted of electrons by the high drain potential and will equilibrate by generating defects which cause the V_{X} shift. This same external perturbation will cause the correcting layer to become p-type, to which it responds by activating more phosphorus dopant atoms. When the device is turned ON (V_{G} high, V_{DS} applied) the device will fully self correct and remove the V_{X} shift. However, when the device is disconnected from its power source, and is in a REST state, after being in the OFF state, the correcting layer will provide an abundant supply of electrons and will virtually eliminate the V_{X} shift by returning the characteristic curve to position H in Figure 4.

It should be noted that because the correcting layer includes both p-type and n-type materials, it corrects both the V_{T} and the V_{X} shift by superactivating the appropriate dopant, as required .

The following explanation represents our present understanding of the mechanism involved in the equilibration of amorphous silicon thin film transistors and is representative of the effects taking place in other active devices, even when the amorphous semiconductor materials used are different. It should be borne in mind that in the substantially intrinsic amorphous silicon charge transport layer, hydrogen is usually used to improve the material by reducing the defect density therein. In the ON state, the gate potential accumulates the charge transport layer causing the bands to bend and electrons in the system at the Fermi level to move into the conduction band. When this happens, these free electrons can readily displace the hydrogen from the silicon and create a defect (dangling bond) which will readily accept and hold a free electron and remove it from the conduction band. The trapped charge, which may be a bulk or interfacial state, opposes the gate field and impedes the band bending, making the charge transport layer less conductive and requiring a higher gate potential to produce the same current output, as represented by the shifted I_{DS} v. V_{G} curve (see Figure 2). Without the correcting layer, the charge transport layer will restore itself partially to its original state by self annealing. With the correcting layer, the charge transport layer speeds its recovery and is restored almost totally to its original state by virtue of the internal changes in the correcting layer which counteract the adverse changes to the charge transport layer. The gate potential also induces electrons into the correcting layer, causing the boron therein to become more active by increasing the number of holes as this layer equilibrates. In the OFF state of the transistor, the charge transport layer has an excess of electrons and the correcting layer has an excess of holes. The holes may attach to the free hydrogen allowing it to be positively charged and to couple with a dangling bond so as to release a trapped electron. In this manner, the charge transport layer once again has a reduced number of defects.

Another source of device instability arises from the trapping of electric charge within the gate dielectric. The correcting layer provided to accelerate the equilibration of the amorphous semiconductor charge transport layer will also serve to supply carriers of the appropriate (opposite) sign for neutralizing the trapped charge. If unassisted, the rate at which the gate dielectric self anneals to remove the trapped charges will be quite slow. The correcting layer substantially increases the rate of removal of the trapped charges.

It should be understood that the provision of a correcting layer as described above enables the fabrication of more stable devices which should have longer lifetimes.

## Claims

1. A thin film transistor, including a gate electrode (30), a gate insulating layer (32), a charge transport layer (34) and a correction layer (36) formed in this sequence and adjacent each other,
the charge transport layer comprising a non-single crystal, semiconductor layer (34) whose electronic structure changes in response to an external perturbation,
the correcting layer comprising a semiconductor layer which contains substantially equal amounts of active n-type and p-type dopants, the correcting layer accelerating removal of said changes by providing carriers of the appropriate sign.

2. A thin film transistor as claimed in claim 1, wherein the correcting layer is a layer of compensated semiconductor material or a superlattice structure (46, 48, 50) including a plurality of semiconductor layers.

3. A thin film transistor as claimed in claim 1 or claim 2, wherein the non-single crystal layer (34) comprises an amorphous material, for example substantially intrinsic amorphous silicon; a microcrystalline material; or a polycrystalline material.

4. A thin film transistor as claimed in any one of the preceding claims, wherein said gate insulating layer (32) traps charges therein, and said correcting layer neutralizes said charges by providing said carriers of the appropriate sign.

5. A thin film transistor as claimed in any one of the preceding claims, wherein the non-single crystal, semiconductor layer (34) has a thickness of 30nm.

6. A thin film transistor as claimed in any one of the preceding claims, wherein the non-single crystal, semiconductor layer is an intrinsic or lightly-doped charge transport layer and the said external perturbation is a positive potential on the gate of the transistor causing a depletion of holes in the charge transport layer.

## Patentansprüche

1. Dünnschicht-Transistor mit einer Gate-Elektrode (30), einer Gate-Isolierschicht (32), einer Ladungstransportschicht (34) und einer Korrekturschicht (36), die in dieser Reihenfolge und aneinander angrenzend gebildet sind,
wobei die Ladungstransportschicht eine Nicht-Einkristall-Halbleiterschicht (34) umfaßt, deren elektronische Struktur sich als Reaktion auf eine äußere Störung verändert,
die Korrekturschicht eine Halbleiterschicht umfaßt, die im wesentlichen gleiche Mengen von aktiven Dotierstoffen des N-Typs und P-Typs enthält, und die Korrekturschicht die Beseitigung dieser Veränderungen durch Bereitstellen von Trägern des geeigneten Vorzeichens beschleunigt.

2. Dünnschicht-Transistor nach Anspruch 1, bei dem die Korrekturschicht eine Schicht aus kompensiertem Halbleitermaterial oder eine Übergitterstruktur (46, 48, 50) ist, die Mehrzahl von Halbleiterschichten umfaßt.

3. Dünnschicht-Transistor nach Anspruch 1 oder 2, bei dem die Nicht-Einkristallschicht (34) ein amorphes Material, z.B. im wesentlichen intrinsisches amorphes Silizium, ein mikrokristallines Material oder ein polykristallines Material umfaßt.

4. Dünnschicht-Transistor nach einem der vorangehenden Ansprüche, bei dem die Gate-Isolierschicht (32) Ladungen darin einfängt und die Korrekturschicht diese Ladungen durch Bereitstellen der Träger des geeigneten Vorzeichens neutralisiert.

5. Dünnschicht-Transistor nach einem der vorangehenden Ansprüche, bei dem die Nicht-Einkristall-Halbleiterschicht (34) eine Dicke von 30nm aufweist.

6. Dünnschicht-Transistor nach einem der vorangehenden Ansprüche, bei dem die Nicht-Einkristall-Halbleiterschicht eine intrinsische oder leicht dotierte Ladungstransportschicht ist und die äußere Störung ein positives Potential am Gate des Transistors ist, das eine Abreicherung von Löchern in der Ladungstransportschicht bewirkt.

## Revendications

1. Transistor à film fin, comportant une électrode de grille (30), une couche isolante de grille (32), une couche de transport de charges (34) et une couche de correction (36), fabriquées dans cet ordre, et au voisinage les unes des autres,
la couche de transport de charges comprenant une couche (34) en semiconducteur, sur un cristal non unique, dont la structure électronique varie en réponse à une perturbation externe,
la couche de correction comprenant une couche en semiconducteur qui contient des quantités pratiquement égales de dopants actifs de type n et de type p, la couche de correction accélérant la disparition de tels changements en produisant des porteurs de signe approprié.

2. Transistor à film fin selon la revendication 1, dans lequel la couche de correction est une couche d'un matériau semiconducteur compensé, ou une structure super-réseau (46, 48, 50) comprenant une pluralité de couches en semiconducteurs.

3. Transistor à film fin selon la revendication 1 ou 2, dans lequel la couche (34) à cristal non unique comporte un matériau amorphe, par exemple du silicium amorphe pratiquement intrinsèque ; un matériau microcristallin ; ou un matériau polycristallin.

4. Transistor à film fin, tel que revendiqué dans l'une quelconque des revendications précédentes, dans lequel la dite couche isolante de grille (32) y capture des charges et la dite couche de correction neutralise les dites charges en produisant des dits porteurs de signe approprié.

5. Transistor à film fin selon l'une quelconque des revendications précédentes, dans lequel la couche (34) en semiconducteur à cristal non unique présente une épaisseur de 30 nm.

6. Transistor à film fin, tel que revendiqué dans l'une quelconque des revendications précédentes, dans lequel la couche en semiconducteur, à cristal non unique, est une couche de transport de charges intrinsèque ou légèrement dopée, et la dite perturbation externe est un potentiel positif appliqué sur la grille du transistor provoquant une déplétion de trous dans la couche de transport de charges.
